# EUROPÄISCHE PATENTSCHRIFT

(11) **EP 1 988 227 B1**
(45) Veröffentlichungstag und Bekanntmachung des Hinweises auf die Patenterteilung: **26.10.2011**
(21) Anmeldenummer: 08000985.5
(22) Anmeldetag: 19.01.2008
(51) Int. Cl.: E04B 7/22, H01L 31/048

(54) **Dach für Hochbauten**
Roof for buildings
Toit pour bâtiments

(30) Priorität: 10.02.2007 DE 202007001982 U
(43) Veröffentlichungstag der Anmeldung: 05.11.2008
(73) Patentinhaber: MDV Dr. Maack GmbH, 21376 Salzhausen (DE)
(72) Erfinder: Aretz, Gordon, 25813 Husum (DE); Feilke, Martin, 24568 Kaltenkirchen (DE); Maack Dr., Peter, 21376 Salzhausen (DE)
(74) Vertreter: Hauck Patent- und Rechtsanwälte

(56) Entgegenhaltungen:
- EP-A1- 0 756 045
- DE-A1- 3 229 208
- DE-A1- 10 000 742
- FR-A1- 2 598 491
- JP-A- 2005 200 829

## Beschreibung

Die Erfindung bezieht sich auf ein Dach für Hochbauten nach Anspruch 1.

Neben den Wänden sollen die Dächer von Hochbauten, z.B. Hallenbauten eine Vielzahl von Funktionen erfüllen, etwa sommerlicher und winterlicher Wärmeschutz, Wärmespeicherfähigkeit, Brandschutz, Feuchtigkeitsschutz, Winddichtheit, gegebenenfalls Schallschutz usw..

Aus FR 2 598 491 A1 ist ein solarer Wassererwärmer für ein Dach oder dergleichen bekannt umfassend einen Wärmetauscher, der mittels des Treibhauseffektes erwärmt wird. Aus DE 32 29 208 A1, die ein Dach gemäß dem Oberbegriff des Anspruchs 1 zeigt, ist eine Heizvorrichtung für Gebäude bekannt, wobei in eine massive äußere Stahlbetonschicht Leitungen für ein Wärmemedium verlegt sind, die an einer Wärmepumpenheizung angeschlossen sind.

Der Erfindung liegt die Aufgabe zugrunde, ein Dach für Hallenbauten zu schaffen, das neben der Erzielung der erwähnten Wirkungen auch für die Gewinnung regenerativer Energie genutzt werden kann. Darüber hinaus soll es industriell auf einfache Weise vorgefertigt und leicht montiert werden können.

Diese Aufgabe wird durch die Merkmale des Anspruchs 1 gelöst.

Das erfindungsgemäße Dach besteht vom Aufbau her aus einzelnen nebeneinander liegenden Dachelementen, die jeweils eine Massivplatte aufweisen. Die Massivplatte, aus Beton, soll gute Wärmeleiteigenschaften aufweisen. Die Platte weist nach einer Ausgestaltung der Erfindung mehrere Vorsprünge auf, insbesondere in Form sogenannter Gitterträger, welche einen Unter- und einen Obergurt aufweisen. Bei einschaligem Aufbau der Dachelemente, welcher keinen Teil der Erfindung darstellt, liegt die Platte oben, und die Gitterträger sind mit ihrem Obergurt in die Platte eingebettet, während der Untergurt im Abstand zur Platte über Diagonalstäbe mit dem Obergurt verbunden ist. In die Platten sind Leitungsabschnitte eingebettet, die zusammen eine Verbindungsleitung ergeben zwecks Verbindung z.B. mit einem Wärmeaustauscher einer thermischen Solaranlage, etwa zur Gewinnung von Warmwasser. Zu diesem Zweck kann die Außenseite der Platten mit einer schwarzen Schicht versehen werden, um ein großes Absorptionsvermögen zu gewährleisten. Alternativ bzw. zusätzlich können auf der Außenseite der Platten Solarzellen angeordnet werden zwecks Gewinnung elektrischer Energie. Hochdächer, z.B. Hallendächer weisen zumeist ein relativ geringes Gefälle und eine relativ große Fläche auf, so daß eine große Auffangfläche für Sonneneinstrahlung gegeben ist und damit die Möglichkeit, Energie in großem Umfang zu gewinnen. Besonders vorteilhaft ist naturgemäß ein Dach für Photovoltaik oder Solarthermie, wenn das Dach bzw. die das Dach tragende Tragkonstruktion um eine Hochachse drehbar gestaltet wird, so daß das Dach jeweils optimal zur Sonneneinstrahlung ausgerichtet werden kann.

Bei der Anordnung von Solarzellen auf den Platten, dienen die Leitungsrohre in den Platten dazu, die Solarzellen zu kühlen. Das von den Solarzellen erwärmte Wasser oder eine andere geeignete Flüssigkeit kann einer Nutzung zugeführt werden.

Bei einer Dachlösung, die nicht Teil der Erfindung ist, können die Dachelemente mit einer Platte mehrere nach unten weisende Vorsprünge aufweisen, über welche sich die Platte über eine elastische Schicht an einer Tragkonstruktion abstützen. Die Tragkonstruktion kann beispielsweise von Doppel-T-Trägern oder auch von Holzbalken gebildet sein. Die Vorsprünge können nach einer Ausgestaltung, die nicht Teil der Erfindung ist von Gitterträgern gebildet sein, deren Obergurt in die Platte eingebettet und deren Untergurt im Abstand zum Obergurt über Diagonalstäbe mit dem Obergurt verbunden ist. Alternativ können Träger aus Stahl, Holz oder Stahlbeton verwendet werden.

Bei einer anderen Lösung sind die Platten z.B. mit Gitterträgern armiert, wobei jedoch die Abstützung der Dachelemente über die Platten an einer Tragkonstruktion erfolgt, wiederum über eine elastische Schicht. Die erwähnten elastischen Schichten haben die Aufgabe, eine Relativbewegung zwischen den Dachelementen bzw. der aus den Dachelementen gebildeten Dachscheibe relativ zur Tragkonstruktion zuzulassen, beispielsweise bei thermischen Dehnungen usw..

Bei der Ausgestaltung der Erfindung ist jeweils eine untere Platte vorgesehen, die sich auf einer Tragkonstruktion abstützt, wiederum vorzugsweise über eine elastische Schicht. Die Platte ist mit nach oben weisenden Vorsprüngen versehen, z.B. Gitterträger oder Träger aus Stahl, Holz oder Stahlbeton, auf die sich eine weitere obere Platte über eine elastische Schicht abstützt. In diesem Falle ist die obere Platte mit Leitungen versehen zwecks Wärmeübertragung auf die in der Leitung fließende Flüssigkeit. Alternativ können Solarzellen auf der Außenseite des Daches montiert werden.

Die Solarzellen können als Module mittels einer gut wärmeleitenden Schicht auf der Außenseite der Platten mit einem wärmeleitenden Kleber verklebt sein. Damit zwischen die Fugen keine Feuchtigkeit eindringt, kann nach einer weiteren Ausgestaltung der Erfindung vorgesehen sein, daß benachbarte Solarzellen bzw. Solarmodule im Bereich der Fugen kantennah auf Dichtungen abgestützt sind, die an Schienen angeordnet sind, die ihrerseits an den Platten befestigt sind. Im Bereich der Fugen sind oberhalb der benachbarten Solarzellen bzw. Module Dichtungsschienen angeordnet, die über Dichtungen beiderseits der Fugen auf den Solarzellen aufliegen. Spannmittel können beide Schienen miteinander verspannen. Auf diese Weise ist eine vollständige Abdichtung im Fugenbereich der Solarmodule gewährleistet.

Anstelle der Aufbringung der Solarmodule oder der solarthermischen Module auf der Außenseite der Platten können diese nach einer weiteren Ausgestaltung der Erfindung in die Platten eingegossen sein. Sie werden daher vor dem Vergießen der Platten in die Schalung eingelegt. Schutzschichten für die Module können zugleich die Dachhaut bilden.

Bei der Verwendung von Solarmodulen können die Platten Rohrleitungen aufweisen, die ebenfalls in die Platten eingegossen sein können, in denen ein Kühlmedium fließt. Bekanntlich entsteht bei der Aktivität der Solarmodule Wärme, die gegebenenfalls abzuführen ist. Das erwärmte Medium kann seinerseits einer Nutzung zugeführt werden, beispielsweise über einen Wärmeaustauscher zur Erzeugung von Warmwasser.

Wenn vornehmend von Massivplatten gesprochen wird, sind damit nicht ausschließlich von spezifischem Gewicht schwere Platten gemeint. Wesentlich ist aber, daß sie eine gute Wärmeleitfähigkeit aufweisen.

Ausführungsbeispiele eines erfindungsgemäßen Daches werden anhand von Zeichnungen nachfolgend näher erläutert.
- Fig. 1: zeigt einen Schnitt durch einen Teil eines Daches, das kein Teil der Erfindung ist.
- Fig. 2: zeigt einen Schnitt durch einen Teil einer Ausführungsform eines Daches nach der Erfindung.
- Fig. 3: zeigt schematisch angedeutet ein Solardach.
- Fig. 4: zeigt zwei Einzelheiten des Daches nach Fig. 3.
- Fig. 5: zeigt eine Abwandlung der Einzelheit eines Daches nach Fig. 2.
- Fig. 6: zeigt eine andere Ausführungsform eines Teils eines erfindungsgemäßen Solardachs im Schnitt.

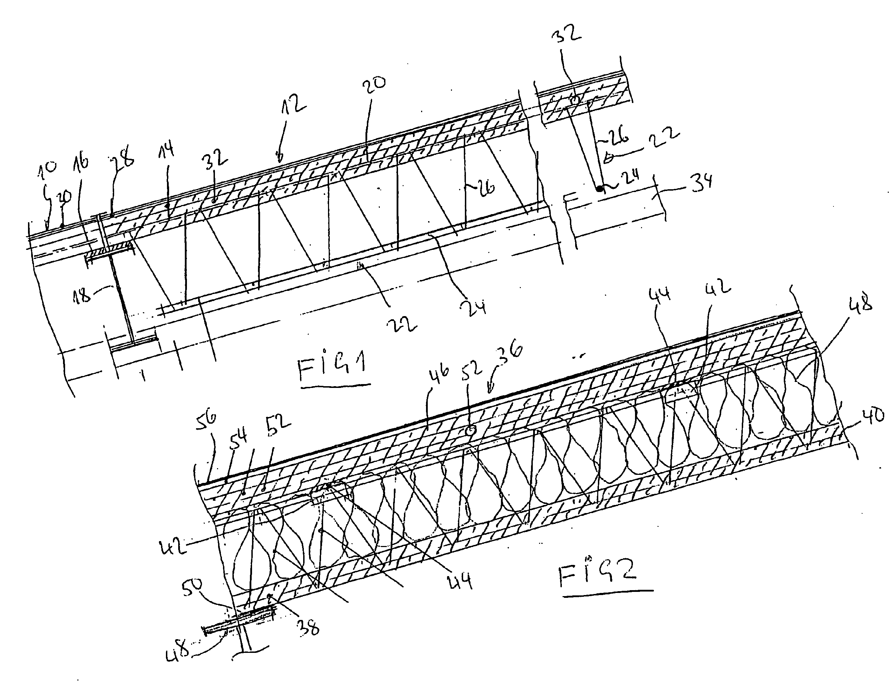

In Fig. 1 sind zwei Dachelemente 10, 12 dargestellt, die nicht Teil der Erfindung sind. Sie weisen eine obere Betonplatte 14 auf. Die Betonplatten benachbarter Dachelemente 10, 12 stützen sich über eine elastische Schicht 16 auf einem Flansch eines Doppel-T-Trägers 18 ab.

In die Betonplatte 14 ist ein Obergurt 20 mindestens eines Gitterträgers 22 eingebettet. Der Obergurt 20 ist mit einem Untergurt 24 über Diagonalstäbe 26 verbunden. Auf der durch die Betonplatten 14 gebildeten Dachfläche ist eine Dichtungsschicht 28 aufgelagert und auf dieser sind Solarzellen 30 angeordnet. Anstelle der Solarzellen 30 kann eine dunkle bzw. schwarze Schicht auf die Dichtungsschicht 30 aufgebracht sein. Anstelle von Gitterträgern können Träger aus Stahl, Holz oder Stahlbeton vorgesehen werden.

In die Betonplatte 14 ist mindestens ein Leitungsrohr 32 eingelassen. Leitungsrohre 32 benachbarter Dachelemente 10, 12 sind miteinander verbunden und bilden eine zusammenhängende Leitung, die mit einem Wärmetauscher einer thermischen Solaranlage verbunden ist. Letzteres ist nicht dargestellt.

In Fig. 1 rechts ist ein Teilschnitt durch die Dachtafel 12 dargestellt.

Unterhalb des Gitterträgers 22 ist eine abgehängte Decke 34 zu erkennen, die am anderen Flansch des Doppel-T-Trägers 18 befestigt ist. Zwischen den Betonplatten 14 und der abgehängten Decke 34 kann Isoliermaterial eingebracht sein.

In Fig. 2 ist ein Dachelement 36 dargestellt, das eine untere Betonplatten 38 aufweist, in welche ein Untergurt 40 eines Gitterträgers eingelassen ist. Der Obergurt des Gitterträgers ist mit Auflageabschnitten 42 versehen, auf denen sich über eine elastische Schicht 44 eine obere Betonplatte 46 abstützt. Die untere Betonplatte 38 stützt sich auf einer nicht weiter dargestellten Stützkonstruktion 48 ab, vorzugsweise über eine elastische Schicht 50. Anstelle von Gitterträgern können Träger aus Holz, Stahl oder Stahlbeton vorgesehen sein.

In der Betonplatte 46 befinden sich Solarthermrohre 52. Auf der Dachfläche ist eine Dichtung 54 aufgelegt und auf dieser sind Solarzellen 56 angeordnet. Zwischen den Platten 40, 46 ist thermisches Dämmaterial 48 angeordnet.

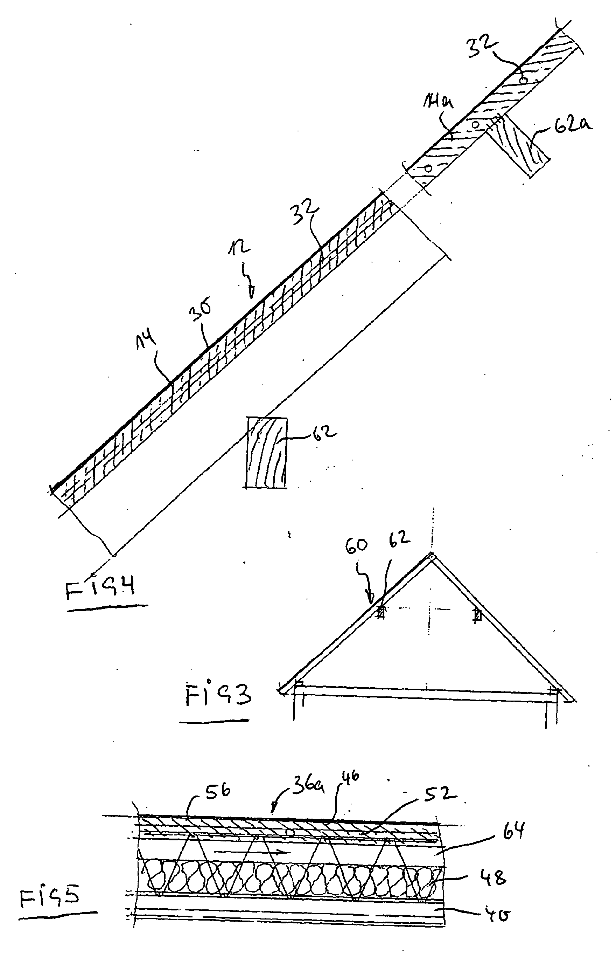

Fig. 3 zeigt angedeutet ein Satteldach 60, das Dachelemente gemäß den Fign. 1 und 2 enthalten kann. Daher ist in Fig. 4 das untere Dachelement mit denselben Bezugszeichen wie in Fig. 1 versehen. Wie erkennbar, stützt sich das Dachelement 12 auf einem Holzbalkenträger 62 ab.

In der Darstellung nach Fig. 4 oben ist eine reine Betonplatte 14a mit Leitungen 32 unmittelbar auf einem Holzbalken 62a aufgelegt. Es versteht sich, daß die beiden Darstellungen nach Fig. 4 alternativ eingesetzt werden.

In Fig. 5 ist ein Dachelement 36a (ähnlich dem nach Fig. 2) dargestellt. Es unterscheidet sich von dem nach Fig. 2 dadurch, daß zwischen der Betonplatte 46 und der wärmedämmenden Schicht 48 ein Hinterlüftungskanal 64 vorgesehen ist. Im übrigen gilt zu Fig. 5 das Gleiche, wie zu Fig. 2 ausgeführt.

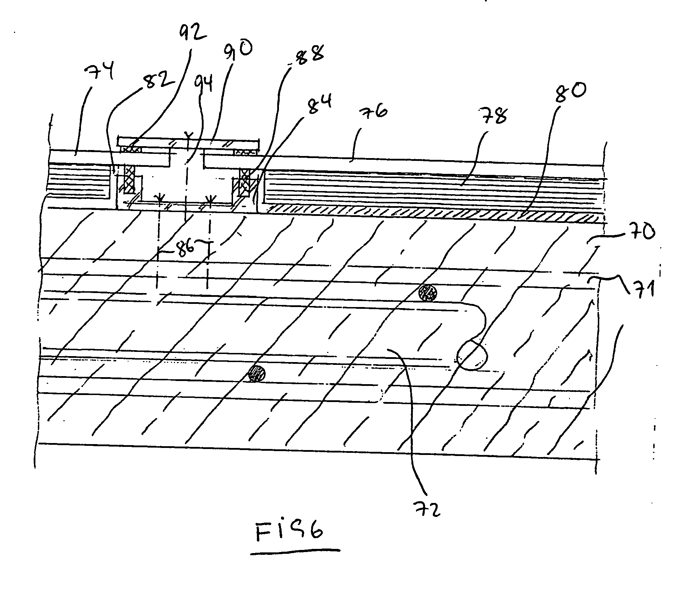

In Fig. 6 ist ein Schnitt durch eine Betonplatte 70 angedeutet, vergleichbar den Betonplatten nach den vorstehenden Figuren. Bei 71 ist eine Bewehrung angedeutet.

Durch die Betonplatte erstreckt sich eine Leitung 72 für ein Kühlmedium. Auf der Betonplatte 70 sind Solarmodule 74, 76 angedeutet. Sie sind über eine sehr gut wärmeleitende Schicht 78 und eine wärmeleitende Klebschicht 80 mit der Außenseite der Betonplatte 70 verbunden. Die Klebschicht 80 ist darüber hinaus elastisch.

Zwischen benachbarten Solarmodulen 74, 76 ist eine Nut 82 vorhanden, welche durch geeignete Mittel abgedichtet ist. Hierzu gehört eine U-förmige Schiene 84, die in geeigneter Weise mit der Betonplatte 70 verschraubt ist, wie bei 86 angedeutet. In die freien Schenkel der U-förmigen Schiene 84 sind Dichtungsbänder 88 eingelassen, auf die sich die Solarmodule 74, 76 kantennah abstützen. Eine flache Schiene 90 erstreckt sich oberhalb der Nut 82 und stützt sich über Dichtungsbänder 92 kantennah auf der Oberseite der Solarmodule 74, 76 ab. Mit Hilfe von Spannschrauben 94 werden die Schienen 84, 90 gegeneinander verspannt, um eine Dichtung im Nutbereich zu bewerkstelligen.

Durch die Leitung fließt ein Kühlmittel, durch das eine Kühlung der Solarmodule 74, 76 erfolgt. Der Wirkungsgrad von Solarmodulen ist größer, wenn sie bei relativ niedrigen Temperaturen arbeiten. Dadurch kommt es zu einer Erwärmung des Kühlmediums in den Leitungen 72, welche wiederum in geeigneter Weise ausgenutzt werden kann, beispielsweise um Wasser zu erwärmen.

## Patentansprüche

1. Dach für Hochbauten, mit einer Trägerkonstruktion und aneinander liegenden Dachelementen (36), die jeweils als obere Platte eine Betonplatte (46) aufweisen, einer dichtenden Schicht (54) auf der Außenseite der oberen Platten (54), in die oberen Platten (54) eingebetteten Leitungsabschnitten (52) zur Verbindung mit einem Wärmetauscher einer thermischen Solaranlage und/oder mit auf der Außenseite der Platten angeordneten Solarzellen, wobei die Dachelemente (36) jeweils auch eine untere Platte (38) aufweisen, die sich auf einer Tragkonstruktion (48) abstützt, vorzugsweise über eine elastische Schicht, **dadurch gekennzeichnet, daß** die unteren Platten (38) nach oben weisende Vorsprünge in Form eines Gitterträgers aufweisen, wobei der Untergurt (40) des Gitterträgers in die untere Platte (38) eingebettet ist, und wobei der Obergurt (42) des Gitterträgers über eine elastische Schicht (44) die obere Platte (54) abstützt.

2. Dach nach Anspruch 1, **dadurch gekennzeichnet, daß** unterhalb des Untergurts eine abgehängte Schicht angeordnet ist.

3. Dach nach einem der Ansprüche 1 oder 2, **dadurch gekennzeichnet, daß** zwischen oberer und unterer Platte eine thermische Isolierung angeordnet ist.

4. Dach nach Anspruch 3, **dadurch gekennzeichnet, daß** zwischen oberer Platte und Isolierung ein Hinterlüftungskanal vorgesehen ist.

5. Dach nach Anspruch 1, **dadurch gekennzeichnet, daß** die Platte Stahl-, Holz- oder Stahlbetonträger aufweist, über welche die obere Platte über die elastische Schicht abgestützt ist.

6. Dach nach einem der Ansprüche 1 bis 5, **dadurch gekennzeichnet, daß** die Solarzellen bzw. Solarmodule mittels einer gut wärmeleitenden Schicht (78) auf der Außenseite der Platten (70) mit wärmeleitendem elastischem Kleber (80) verklebt sind.

7. Dach nach einem der Ansprüche 1 bis 6, **dadurch gekennzeichnet, daß** benachbarte Solarzellen bzw. -module (74, 76) im Bereich der Fugen (82) kantennah auf Dichtungen abgestützt sind, die an Schienen (84) angeordnet sind, die ihrerseits an den Platten (70) befestigt sind und im Bereich der Fugen (82) oberhalb benachbarter Solarzellen bzw. -module (74, 76) beiderseits der Fugen (82) auf den Solarzellen bzw. -modulen (74, 76) aufliegen und Spannmittel (94) vorgesehen sind, welche die oberen und unteren Schienen (90, 84) gegeneinander verspannen.

8. Dach nach Anspruch 7, **dadurch gekennzeichnet, daß** die Dichtungen von Dichtungsbändern (88, 92) gebildet sind.

9. Dach nach einem der Ansprüche 1 bis 8, **dadurch gekennzeichnet, daß** Solarmodule und/oder solarthermische Module in die Platte eingegossen sind.

10. Dach nach Anspruch 9, **dadurch gekennzeichnet, daß** Schutzschichten für die eingegossenen Module die Dachhaut bilden.

11. Dach nach Anspruch 9 oder 10, **dadurch gekennzeichnet, daß** Solarmodule zusammen mit Rohrmodulen in die Platten eingegossen sind.

## Claims

1. A roof for buildings, with a beam structure and adjacent roof elements (36) each having a concrete plate (46) as the top plate, with a sealing layer (54) on the outer side of the top plates (54), conduction sections (52) embedded into the top plates (54) for connection to a heat exchanger of a solar thermal installation and/or to solar cells that are fixed on the outer side of the plates, wherein the roof elements (36) each have also a bottom plate (38) which is supported on a supporting structure (48), preferably via an elastic layer, **characterised in that** the bottom plates (38) have upside-pointing projections in the form of a lattice girder, wherein the bottom boom (40) of the lattice girder is embedded into the bottom plate (38) and wherein the top boom (42) of the lattice girder supports the top plate (54) via an elastic layer (44).

2. The roof according to claim 1, **characterised in that** a suspended layer is disposed below the lower boom.

3. A roof according to claim 1 or 2, **characterised in that** a thermal insulation is disposed between the top plate and the bottom plate.

4. The roof according to claim 3, **characterised in that** a rear ventilation channel is provided between the top plate and the insulation.

5. The roof according to claim 1, **characterised in that** the plate has girders made of steel, wood or steel reinforced concrete, by which the top plate is supported via the elastic layer.

6. A roof according to any one of claims 1 to 5, **characterised in that** the solar cells or solar modules, respectively, are glued together by a heat-conducting elastic glue (80) by means of a fairly heat-conducting layer (78) on the outer side of the plates (70).

7. A roof according to any one of claims 1 to 6, **characterised in that** neighbouring solar cells or modules (74, 76), respectively, are supported on seals near to their edges in the region of the joints (82), said seals being disposed on rails (84) which are in turn fastened on the plates (70) and rest on the solar cells or modules (74, 76), respectively, in the region of the joints (82) on both sides of the joints (82) above neighbouring solar cells or modules (74, 76), respectively, and that tensioning means are provided which tension the upper and the lower rails (90, 84) against each other.

8. The roof according to claim 7, **characterised in that** the seals are formed by sealing tapes.

9. A roof according to any one of claims 1 to 9, **characterised in that** solar modules and/or solar thermal modules are cast into the plate.

10. The roof according to claim 9, **characterised in that** protective layers for the cast-in modules form the roof's vapour seal.

11. A roof according to claim 9 or 10, **characterised in that** solar modules are cast into the plates together with pipe modules.

## Revendications

1. Toit pour bâtiments, avec une structure à poutres et des éléments de toit (36) adjacents, chacun ayant une plaque de béton (46) comme plaque supérieure, avec une couche d'étanchéité (54) sur le côté extérieur des plaques supérieures (54), des sections de conduction (52) encastrés dans les plaques supérieures (54) pour la connexion à un échangeur de chaleur d'une installation solaire thermique et/ou à des cellules solaires disposées sur le côté extérieur des plaques, les éléments de toit (36) chacun ayant aussi une plaque inférieure (38) qui est supportée par une structure porteuse (48), de préférence à travers une couche élastique, **caractérisé en ce que** les plaques inférieures (38) ont des parties en saillie montrant vers le haut en forme de poutre en treillis, la membrure inférieure (40) du poutre en treillis étant encastrée dans la plaque inférieure (38) et la membrure supérieure (42) du poutre en treillis supportant la plaque supérieure (54) à travers une couche élastique (44).

2. Toit selon la revendication 1, **caractérisé en ce que** une couche suspendue est disposée au-dessous de la membrure inférieure.

3. Toit selon la revendication 1 ou 2, **caractérisé en ce que** un isolement thermique est disposé entre les plaques supérieure et inférieure.

4. Toit selon la revendication 3, **caractérisé en ce que** un conduit de ventilation en arrière est pourvu entre la plaque supérieure et l'isolement.

5. Toit selon la revendication 1, **caractérisé en ce que** la plaque a des poutres en acier, en bois ou en béton armé à travers lesquels la plaque supérieure est supportée via la couche élastique.

6. Toit selon l'une quelconque des revendications 1 à 5, **caractérisé en ce que** les cellules solaires ou respectivement modules solaires sont collé(e)s avec une colle (80) élastique conducteur de la chaleur par le biais d'une couche (78) bon conducteur de la chaleur sur le côté extérieur des plaques (70).

7. Toit selon l'une quelconque des revendications 1 à 6, **caractérisé en ce que** des cellules solaires ou respectivement modules solaires (74, 76) avoisinant(e)s sont supportés dans la région des joints (82) prés des arêtes sur des garnitures qui sont disposées sur des rails (84) qui sont à leur côté fixés sur les plaques (70) et qui restent sur les cellules solaires ou respectivement modules solaires (74, 76) dans la région des joints (82) au-dessus de cellules solaires ou respectivement modules solaires (74, 76) avoisinants de part et d'autre des joints (82), et que des moyens de précontrainte (94) sont pourvus qui encastrent les rails supérieur et inférieur (90, 84) par rapport de l'un à l'autre.

8. Toit selon la revendication 7, **caractérisé en ce que** les garnitures sont formées par des bandes d'étanchéité (88, 92).

9. Toit selon l'une quelconque des revendications 1 à 9, **caractérisé en ce que** des modules solaires et/ou modules solaires thermiques sont coulés dans la plaque.

10. Toit selon la revendication 9, **caractérisé en ce que** des couches de protection pour les modules coulés forment la toiture.

11. Toit selon la revendication 9 ou 10, **caractérisé en ce que** des modules solaires sont coulés dans les plaques ensemble avec des modules de tube.
